# EUROPEAN PATENT SPECIFICATION

(11) **EP 3 381 247 B1**
(45) Date of publication and mention of the grant of the patent: **18.08.2021**
(21) Application number: 16888509.3
(22) Date of filing: 29.01.2016
(51) Int. Cl.: H05K 7/14, G06F 1/18

(54) **SERVER ENCLOSURES INCLUDING TWO POWER BACKPLANES**
SERVERGEHÄUSE MIT ZWEI LEISTUNGSRÜCKWANDPLATINEN
ENCEINTES DE SERVEUR COMPRENANT DEUX PANNEAUX ARRIÈRE D'ALIMENTATION

(43) Date of publication of application: 03.10.2018
(73) Proprietor: Hewlett Packard Enterprise Development LP, Houston, TX 77070 (US)
(72) Inventor: MICHNA, Vincent W., Houston, Texas 77070 (US); PURCELL, Brian T., Houston, Texas 77070 (US); MOHR, David P., Houston, Texas 77070 (US); HARRIS, Chandler Ray, Houston, Texas 77070 (US)
(74) Representative: Iqbal, Md Mash-Hud
(86) International application number: PCT/US2016/015820
(87) International publication number: WO 2017/131781

(56) References cited:
- WO-A1-2014/153592
- US-A1- 2004 184 249
- US-A1- 2006 221 524
- US-A1- 2009 174 256
- US-A1- 2012 026 667
- US-A1- 2012 243 160
- US-A1- 2014 118 914
- US-A1- 2014 254 074

## Description

### Background

A plurality of computing devices (e.g., servers), network switches, management modules, power supplies, and cooling devices may be installed within a server enclosure. The power supplies may supply power to the other devices installed within the server enclosure. Alternatively, the server enclosure may receive power from external power supplies and distribute the power to the devices installed within the server enclosure.

US 2012/0243160 A1 discloses an adaptive computing system generally including modular control, switching, and power supply architecture. In particular, the adaptive computing system provides a platform supporting multiple independent desktop computer modules that occupy less physical space than a standalone commercial computer, provide performance density comparable to current server solutions, and address concerns relating to stability, safety, productivity, performance, assembly, service, and other factors important to diverse desktop computer user communities.

US 2006/0221524 A1 discloses a method of monitoring a power distribution unit including providing a power distribution unit frame, where the power distribution unit frame has a 2U form factor, and where the power distribution unit frame is coupled to mount in an embedded computer frame. An alarm module is coupled to a circuit breaker connection site in the power distribution unit frame.

A server enclosure according to the invention is provided in claim 1. A method of using the server enclosure is provided in claim 9.

### Brief Description of the Drawings

Figure 1 is a schematic diagram illustrating one example of a server enclosure.
Figure 2 is a schematic diagram illustrating one example of the server enclosure of Figure 1 with installed devices.
Figure 3 is a schematic diagram illustrating another example of a server enclosure.
Figure 4 is a block diagram illustrating one example of a system.
Figure 5 is a flow diagram illustrating one example of a method for fabricating a system.

### Detailed Description

In the following detailed description, reference is made to the accompanying drawings which form a part hereof, and in which is shown by way of illustration specific examples in which the disclosure may be practiced. It is to be understood that other examples may be utilized and structural or logical changes may be made without departing from the scope of the present disclosure. The following detailed description, therefore, is not to be taken in a limiting sense, and the scope of the present disclosure is defined by the appended claims. It is to be understood that features of the various examples described herein may be combined, in part or whole, with each other, unless specifically noted otherwise.

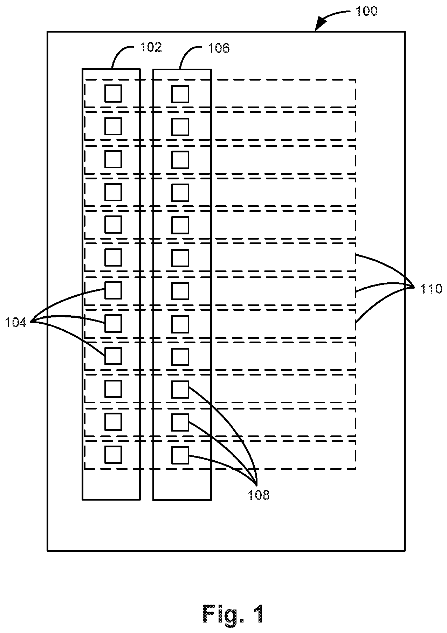

Figure 1 is a schematic diagram illustrating one example of a server enclosure 100. Enclosure 100 includes a first power backplane 102, a second power backplane 106, and a plurality of slots indicated for example at 110 for receiving devices. First power backplane 102 includes a plurality of first power connectors indicated for example at 104. Each first power connector 104 may be electrically coupled to a first power input of a device installed in a slot 110 corresponding to the first power connector 104. Each first power connector 104 is electrically coupled to a first power supply (not shown) providing first power to first power backplane 102. Second power backplane 106 includes a plurality of second power connectors indicated for example at 108. Each second power connector 108 may be electrically coupled to a second power input of a device installed in a slot 110 corresponding to the second power connector 108. Each second power connector 108 is electrically coupled to a second power supply (not shown) providing second power to second power backplane 106.

The power distributed by first power backplane 102 to each first power connector 104 has a voltage less than the voltage of the power distributed by second power backplane 106 to each second power connector 108. In one example, first power backplane 102 is a low voltage direct current (LVDC) backplane and second power backplane 106 is a high voltage direct current (HVDC) backplane. The HVDC power distributed by the HVDC backplane may have a voltage within the range between 360 VDC and 380 VDC, and the LVDC power distributed by the LVDC backplane may have a voltage within the range between 12 VDC and 48 VDC. In other examples, the HVDC power and the LVDC power may have other suitable voltages where the voltage of the HVDC power is greater than the voltage of the LVDC power.

A device installed in a slot 110 may be powered by first power backplane 102 or second power backplane 106. For example, a higher power device (e.g., liquid cooled server) may be powered by second power backplane 106 while a lower power device (e.g., network switch, air cooled server) may be powered by first power backplane 102. A device installed in a slot 110 may also be electrically coupled to both first power backplane 102 and second power backplane 106. In this case, first power backplane 102 provides first power to a first portion of the device and second power backplane 106 provides second power to a second portion of the device.

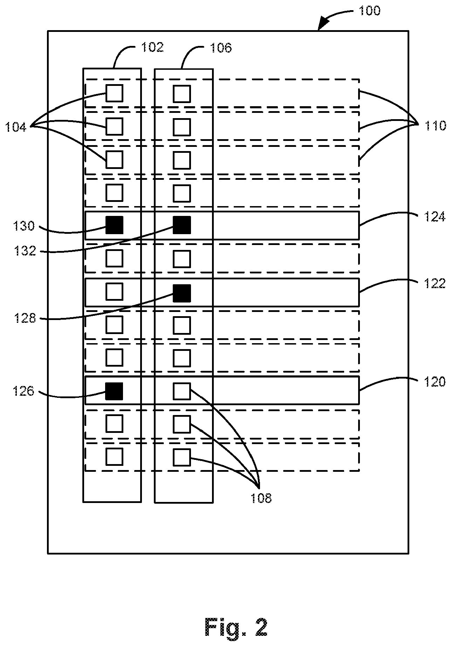

Figure 2 is a schematic diagram illustrating one example of server enclosure 100 previously described and illustrated with reference to Figure 1 with installed devices 120, 122, and 124. Each device 120, 122, and 124 is installed in a slot 110. Device 120 includes a first power input electrically coupled to a first power connector 104 of first power backplane 102 as indicated at 126. Device 120 receives first power from first power backplane 102 to power device 120. Device 120 is electrically isolated from second power backplane 106. Device 122 includes a second power input electrically coupled to a second power connector 108 of second power backplane 106 as indicated at 128. Device 122 receives second power from second power backplane 106 to power device 122. Device 122 is electrically isolated from first power backplane 102.

Device 124 includes a first power input electrically coupled to a first power connector 104 of first power backplane 102 as indicated at 130. Device 124 also includes a second power input electrically coupled to a second power connector 108 of second power backplane 106 as indicated at 132. Device 124 receives first power from first power backplane 102 to power a first portion of device 124. Device 124 receives second power from second power backplane 106 to power a second portion of device 124.

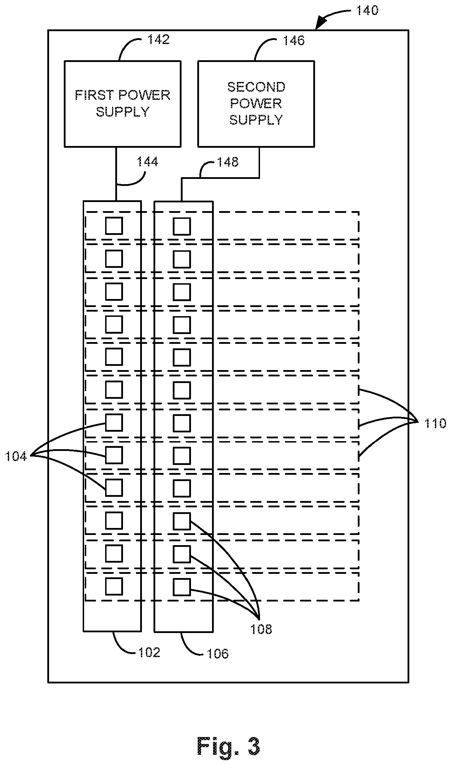

Figure 3 is a schematic diagram illustrating another example of a server enclosure 140. Server enclosure 140 includes a first power backplane 102, a second power backplane 106, and a plurality of slots 110 as previously described and illustrated with reference to Figure 1. In addition, server enclosure 140 includes a first power supply 142 and a second power supply 146. First power supply 142 is electrically coupled to first power backplane 102 through a power transmission path 144. Second power supply 146 is electrically coupled to second power backplane 106 through a power transmission path 148. In one example, first power supply 142 converts line power to provide LVDC power to first power backplane 102 and second power supply 146 converts line power to provide HVDC power to second power backplane 106. In other examples, first power supply 142 provides power to first power backplane 102 having another suitable voltage less than a voltage of power provided to second power backplane 106 by second power supply 146.

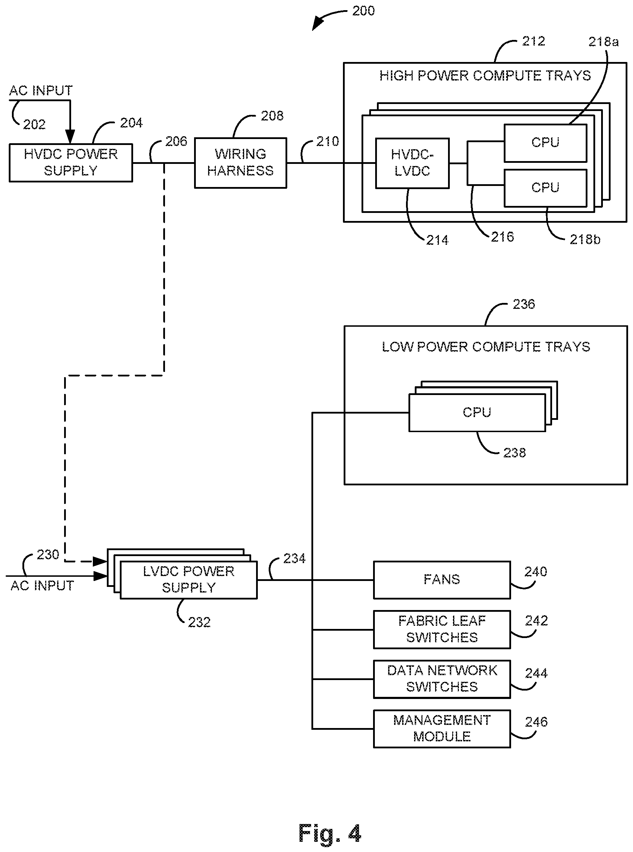

Figure 4 is a block diagram illustrating one example of a system 200. System 200 may be installed into a server enclosure, such as server enclosure 100 previously described and illustrated with reference to Figure 1. System 200 includes a HVDC power supply 204, a wiring harness 208, high power compute trays 212, at least one LVDC power supply 232, low power compute trays 236, fans 240, fabric leaf switches 242, data network switches 244, and a management module 246.

The input of HVDC power supply 204 receives an AC input (e.g., line power) through a power transmission path 202. The output of HVDC power supply 204 is electrically coupled to wiring harness 208 through a HVDC power transmission path 206. In one example, the output of HVDC power supply 204 is also electrically coupled to the input of the at least one LVDC power supply 232. In other examples, the output of HVDC power supply 204 is not electrically coupled to the input of the at least one LVDC power supply 232. HVDC power supply 204 converts AC line power to provide HVDC power on HVDC power transmission path 206. Wiring harness 208 is electrically coupled to high power compute trays 212 through a HVDC power transmission path 210. Wiring harness 208 passes HVDC power from HVDC power supply 204 to HVDC transmission path 210. In one example, wiring harness 208 and HVDC power transmission path 210 include a power backplane electrically coupled to a plurality of power connectors, such as second power backplane 106 and second power connectors 108 previously described and illustrated with reference to Figure 1.

Each high power compute tray includes a HVDC to LVDC converter 214 and central processing units (CPUs) 218a and 218b. The input of the HVDC to LVDC converter 214 of each high power compute tray receives HVDC power from HVDC power supply 204. The HVDC to LVDC converter 214 of each high power compute tray converts the received HVDC power to provide LVDC power to each CPU 218a and 218b within the corresponding high power compute tray through a LVDC power transmission path 216. In one example, high power compute trays 212 are liquid cooled. In other examples, high power compute trays 212 may have other suitable configurations (e.g., a different number of CPUs) but in each example may include a HVDC to LVDC converter.

The input of the at least one LVDC power supply 232 receives an AC input (e.g., line power) through a power transmission path 230. Alternatively, or in addition, the input of the at least one LVDC power supply 232 receives HVDC power from HVDC power supply 204. The output of the at least one LVDC power supply 232 is electrically coupled to at least one of low power compute trays 236, fans 240, fabric leaf switches 242, data network switches 244, and management module 246 through a LVDC power transmission path 234. The at least one LVDC power supply 232 converts AC line power and/or HVDC power to provide LVDC power on LVDC power transmission path 234. In one example, LVDC power transmission path 234 includes a power backplane electrically coupled to a plurality of power connectors, such as first power backplane 102 and second power connectors 104 previously described and illustrated with reference to Figure 1.

In one example, each low power compute tray includes a CPU 238. The LVDC power on LVDC power transmission path 234 powers each CPU 238. In one example, low power compute trays 236 are air cooled. In other examples, low power compute trays 238 may have other suitable configurations but in each example receive LVDC power for operating each low power compute tray. Fans 240, fabric leaf switches 242, data network switches 244, and/or management module 246 receive LVDC power for operating each device.

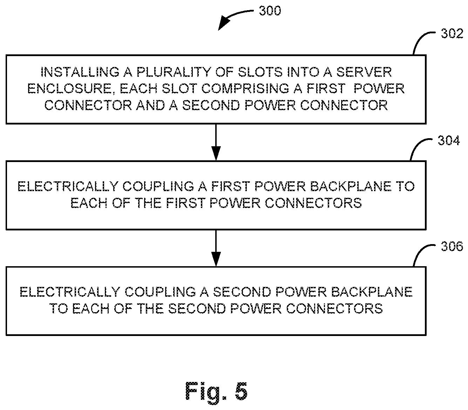

Figure 5 is a flow diagram illustrating one example of a method 300 for fabricating a system. At 302, method 300 includes installing a plurality of slots into a server enclosure, each slot comprising a first power connector and a second power connector. At 304, method 300 includes electrically coupling a first power backplane to each of the first power connectors. At 306, method 300 includes electrically coupling a second power backplane to each of the second power connectors.

In one example, the method further includes installing a first device into a first slot of the plurality of slots to electrically couple the first device to the first power connector of the first slot. The method may also include installing a second device into a second slot of the plurality of slots to electrically couple the second device to the second power connector of the second slot. In addition, the method may further include installing a power supply into the server enclosure to convert line power to provide low voltage direct current (LVDC) power to the first power backplane. Further, the method may include installing a power supply into the server enclosure to convert line power to provide high voltage direct current (HVDC) power to the second power backplane. Although specific examples have been illustrated and described herein, a variety of alternate and/or equivalent implementations may be substituted for the specific examples shown and described without departing from the scope of the invention, which is defined and limited only by the appended claims.

## Claims

1. A server enclosure (140) comprising:
a plurality of slots (110), each slot comprising a first power connector (104) and a second power connector (108);
a first power backplane (102) electrically coupled to each of the first power connectors (104); and
a second power backplane (106) electrically coupled to each of the second power connectors (108);
**characterized in that** the first power backplane (102) distributes between 12 VDC and 48 VDC to each first power connector (104), and the second power backplane (106) distributes between 360 VDC and 380 VDC to each second power connector (108).

2. The server enclosure of claim 1, further comprising:
a power supply (142) electrically coupled to the first power backplane (102), the power supply to convert line power to low voltage direct current "LVDC" power.

3. The server enclosure of claim 1, further comprising:
a power supply (146) electrically coupled to the second power backplane (106), the power supply (146) to convert line power to high voltage direct current "HVDC" power.

4. A system comprising:
a server enclosure according to claim 1;
a first device installed in a first slot of the plurality of slots (110), the first device electrically coupled to the first power connector (104) of the first slot; and
a second device installed in a second slot of the plurality of slots (110), the second device electrically coupled to the second power connector (108) of the second slot.

5. The system of claim 4, wherein the first device comprises high voltage direct current "HVDC" to low voltage direct current "LVDC" converter, and wherein the first device is electrically isolated from the second power backplane (106).

6. The system of claim 4, further comprising:
a third device installed in a third slot of the plurality of slots (110), the third device electrically coupled to the first power connector (104) and the second power connector (108).

7. The system of claim 4, further comprising:
a power supply (142) to convert line power to provide LVDC power to the first power backplane (102).

8. The system of claim 4, further comprising:
a power supply (146) to convert line power to provide HVDC power to the second power backplane (106).

9. A method comprising:
installing a plurality of slots (110) into a server enclosure (140) each slot
comprising a first power connector (104) and a second power connector (108);
electrically coupling a first power backplane (102) to each of the first power connectors (104); and
electrically coupling a second power backplane (106) to each of the second power connectors (108),
**characterized in that** the first power backplane (102) distributes between 12 VDC and 48 VDC to each first power connector (104), and the second power backplane (106) distributes between 360 VDC and 380 VDC to each second power connector (108).

10. The method of claim 9, further comprising:
installing a device into a first slot of the plurality of slots (110) to electrically couple the device to the first power connector (104) of the first slot.

11. The method of claim 9, further comprising:
installing a device into a first slot of the plurality of slots (110) to electrically couple the device to the second power connector (108) of the first slot.

12. The method of claim 9, further comprising:
installing a power supply (142) into the server enclosure (104) to convert line power to provide low voltage direct current "LVDC" power to the first power backplane (102).

13. The method of claim 9, further comprising:
installing a power supply (146) into the server enclosure (104) to convert line power to provide high voltage direct current "HVDC" power to the second power backplane (106).

## Patentansprüche

1. Servergehäuse (140), das Folgendes umfasst:
mehrere Schlitze (110), wobei jeder Schlitz einen ersten Stromstecker (104) und einen zweiten Stromstecker (108) umfasst;
eine erste Strom-Backplane (102), die mit jedem der ersten Stromstecker (104) elektrisch gekoppelt ist; und
eine zweite Strom-Backplane (106), die mit jedem der zweiten Stromstecker (108) elektrisch gekoppelt ist;
**dadurch gekennzeichnet, dass** die erste Strom-Backplane (102) zwischen 12 VDC und 48 VDC an jeden ersten Stromstecker (104) verteilt und die zweite Strom-Backplane (106) zwischen 360 VDC und 380 VDC an jeden zweiten Stromstecker (108) verteilt.

2. Servergehäuse nach Anspruch 1, das ferner Folgendes umfasst:
eine Stromversorgung (142), die mit der ersten Strom-Backplane (102) elektrisch gekoppelt ist, wobei die Stromversorgung Netzstrom in Niederspannungsgleichstrom(*Low Voltage Direct Current-* LVDC)-Leistung umwandelt.

3. Servergehäuse nach Anspruch 1, das ferner Folgendes umfasst:
eine Stromversorgung (146), die mit der zweiten Strom-Backplane (106) elektrisch gekoppelt ist, wobei die Stromversorgung (146) Netzstrom in Hochspannungsgleichstrom(*High Voltage Direct Current-* HVDC)-Leistung umwandelt.

4. System, das Folgendes umfasst:
ein Servergehäuse nach Anspruch 1;
eine erste Vorrichtung, die in einem ersten Schlitz der mehreren Schlitzen (110) installiert ist, wobei die erste Vorrichtung mit dem ersten Stromstecker (104) des ersten Schlitzes elektrisch gekoppelt ist; und
eine zweite Vorrichtung, die in einem zweiten Schlitz der mehreren Schlitze (110) installiert ist, wobei die zweite Vorrichtung mit dem zweiten Stromstecker (108) des zweiten Schlitzes elektrisch gekoppelt ist.

5. System nach Anspruch 4, wobei die erste Vorrichtung einen Hochspannungsgleichstrom(HVDC)-zu-Niederspannungsgleichstrom(LVDC)-Umwandler umfasst und wobei die erste Vorrichtung von der zweiten Strom-Backplane (106) elektrisch isoliert ist.

6. System nach Anspruch 4, das ferner Folgendes umfasst:
eine dritte Vorrichtung, die in einem dritten Schlitz der mehreren Schlitze (110) installiert ist, wobei die dritte Vorrichtung mit dem ersten Stromstecker (104) und dem zweiten Stromstecker (108) elektrisch gekoppelt ist.

7. System nach Anspruch 4, das ferner Folgendes umfasst:
eine Stromversorgung (142), um Netzstrom umzuwandeln, um der ersten Strom-Backplane (102) LVDC-Strom bereitzustellen.

8. System nach Anspruch 4, das ferner Folgendes umfasst:
eine Stromversorgung (146), um Netzstrom umzuwandeln, um der zweiten Strom-Backplane (106) HVDC-Strom bereitzustellen.

9. Verfahren, das Folgendes umfasst:
Installieren mehrerer Schlitze (110) in einem Servergehäuse (140), wobei jeder Schlitz einen ersten Stromstecker (104) und einen zweiten Stromstecker (108) umfasst;
elektrisches Koppeln einer ersten Strom-Backplane (102) mit jedem der ersten Stromstecker (104); und
elektrisches Koppeln einer zweiten Strom-Backplane (106) mit jedem der zweiten Stromstecker (108),
**dadurch gekennzeichnet, dass** die erste Strom-Backplane (102) zwischen 12 VDC und 48 VDC an jeden ersten Stromstecker (104) verteilt und die zweite Strom-Backplane (106) zwischen 360 VDC und 380 VDC an jeden zweiten Stromstecker (108) verteilt.

10. Verfahren nach Anspruch 9, das ferner Folgendes umfasst:
Installieren einer Vorrichtung in einem ersten Schlitz der mehreren Schlitze (110), um die Vorrichtung mit dem ersten Stromstecker (104) des ersten Schlitzes elektrisch zu koppeln.

11. Verfahren nach Anspruch 9, das ferner Folgendes umfasst:
Installieren einer Vorrichtung in einem ersten Schlitz der mehreren Schlitze (110), um die Vorrichtung mit dem zweiten Stromstecker (108) des ersten Schlitzes elektrisch zu koppeln.

12. Verfahren nach Anspruch 9, das ferner Folgendes umfasst:
Installieren einer Stromversorgung (142) in dem Servergehäuse (104), um Netzstrom umzuwandeln, um der ersten Strom-Backplane (102) Niederspannungsgleichstrom(LVDC)-Leistung bereitzustellen.

13. Verfahren nach Anspruch 9, das ferner Folgendes umfasst:
Installieren einer Stromversorgung (146) in dem Servergehäuse (104), um Netzstrom umzuwandeln, um der zweiten Strom-Backplane (106) Hochspannungsgleichstrom(HVDC)-Leistung bereitzustellen.

## Revendications

1. Enceinte de serveur (140) comprenant :
une pluralité de logements (110), chaque logement comprenant un premier connecteur d'alimentation (104) et un second connecteur d'alimentation (108) ;
un premier fond de panier d'alimentation (102) couplé électriquement à chacun des premiers connecteurs d'alimentation (104) ; et
un second fond de panier d'alimentation (106) couplé électriquement à chacun des seconds connecteurs d'alimentation (108) ;
**caractérisée en ce que** le premier fond de panier d'alimentation (102) distribue entre 12 Vcc et 48 Vcc à chaque premier connecteur d'alimentation (104), et le second fond de panier d'alimentation (106) distribue entre 360 Vcc et 380 Vcc à chaque second connecteur d'alimentation (108).

2. Enceinte de serveur selon la revendication 1, comprenant en outre :
une alimentation électrique (142) couplée électriquement au premier fond de panier d'alimentation (102), l'alimentation électrique permettant de convertir la puissance de ligne en alimentation de courant continu basse tension « LVDC ».

3. Enceinte de serveur selon la revendication 1, comprenant en outre :
une alimentation électrique (146) couplée électriquement au second fond de panier d'alimentation (106), l'alimentation électrique (146) permettant de convertir la puissance de ligne en alimentation de courant continu haute tension « HVDC ».

4. Système comprenant :
une enceinte de serveur selon la revendication 1 ;
un premier dispositif installé dans un premier logement de la pluralité de logements (110), le premier dispositif étant couplé électriquement au premier connecteur d'alimentation (104) du premier logement ; et
un deuxième dispositif installé dans un second logement de la pluralité de logements (110), le deuxième dispositif étant couplé électriquement au second connecteur d'alimentation (108) du second logement.

5. Système selon la revendication 4, dans lequel le premier dispositif comprend un convertisseur de courant continu haute tension « HVDC » en courant continu basse tension « LVDC », et dans lequel le premier dispositif est isolé électriquement du second fond de panier d'alimentation (106).

6. Système selon la revendication 4, comprenant en outre :
un troisième dispositif installé dans un troisième logement de la pluralité de logements (110), le troisième dispositif étant couplé électriquement au premier connecteur d'alimentation (104) et au second connecteur d'alimentation (108).

7. Système selon la revendication 4, comprenant en outre :
une alimentation électrique (142) pour convertir la ligne d'alimentation afin de fournir une alimentation LVDC au premier fond de panier d'alimentation (102).

8. Système selon la revendication 4, comprenant en outre :
une alimentation électrique (146) pour convertir la ligne d'alimentation afin de fournir une alimentation HVDC au second fond de panier d'alimentation (106).

9. Procédé comprenant :
l'installation d'une pluralité de logements (110) dans une enceinte de serveur (140), chaque logement comprenant un premier connecteur d'alimentation (104) et un second connecteur d'alimentation (108) ;
le couplage électrique d'un premier fond de panier d'alimentation (102) à chacun des premiers connecteurs d'alimentation (104) ; et
le couplage électrique d'un second fond de panier d'alimentation (106) à chacun des seconds connecteurs d'alimentation (108),
**caractérisé en ce que** le premier fond de panier d'alimentation (102) distribue entre 12 Vcc et 48 Vcc à chaque premier connecteur d'alimentation (104), et le second fond de panier d'alimentation (106) distribue entre 360 Vcc et 380 Vcc à chaque second connecteur d'alimentation (108).

10. Procédé selon la revendication 9, comprenant en outre :
l'installation d'un dispositif dans un premier logement de la pluralité de logements (110) pour coupler électriquement le dispositif au premier connecteur d'alimentation (104) du premier logement.

11. Procédé selon la revendication 9, comprenant en outre :
l'installation d'un dispositif dans un premier logement de la pluralité de logements (110) pour coupler électriquement le dispositif au second connecteur d'alimentation (108) du premier logement.

12. Procédé selon la revendication 9, comprenant en outre :
l'installation d'une alimentation électrique (142) dans l'enceinte de serveur (104) pour convertir la ligne d'alimentation afin de fournir une alimentation en courant continu basse tension « LVDC » au premier fond de panier d'alimentation (102).

13. Procédé selon la revendication 9, comprenant en outre :
l'installation d'une alimentation électrique (146) dans l'enceinte de serveur (104) pour convertir la ligne d'alimentation afin de fournir une alimentation en courant continu haute tension « HVDC » au second fond de panier d'alimentation (106).
